(19) **Europäisches Patentamt / European Patent Office / Office européen des brevets**

(11) **EP 4 027 550 B1**

(12) **EUROPEAN PATENT SPECIFICATION**

(45) Date of publication and mention
of the grant of the patent:
**26.06.2024 Bulletin 2024/26**

(21) Application number: **21793848.9**

(22) Date of filing: **22.03.2021**

(51) International Patent Classification (IPC):
**H04L 1/00** *(2006.01)* **H04W 4/80** *(2018.01)*
**H03M 13/23** *(2006.01)* **H03M 13/41** *(2006.01)*
**H03M 13/09** *(2006.01)*

(52) Cooperative Patent Classification (CPC):
**H04L 1/0053; H03M 13/23; H03M 13/41;
H03M 13/4169; H04L 1/0054; H04L 1/0059;
H04W 4/80;** H03M 13/09; H04B 2201/71346

(86) International application number:
**PCT/CN2021/082158**

(87) International publication number:
**WO 2022/099967 (19.05.2022 Gazette 2022/20)**

(54) **DECODING IMPLEMENTATION METHOD FOR BLUETOOTH RECEIVER**

DECODIERUNGSIMPLEMENTIERUNGSVERFAHREN FÜR BLUETOOTH-EMPFÄNGER

PROCÉDÉ DE MISE EN OEUVRE DE DÉCODAGE POUR RÉCEPTEUR BLUETOOTH

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.11.2020 CN 202011255688**

(43) Date of publication of application:
**13.07.2022 Bulletin 2022/28**

(73) Proprietor: **Nanjing Qinheng Microelectronics Co.,
Ltd.
Yuhuatai District
Nanjing, Jiangsu 210012 (CN)**

(72) Inventor: **LIU, Deliang
Nanjing, Jiangsu 210012 (CN)**

(74) Representative: **Murgitroyd & Company
165-169 Scotland Street
Glasgow G5 8PL (GB)**

(56) References cited:
WO-A1-2016/057431  CN-A- 101 272 151
CN-A- 102 064 839  CN-A- 111 385 779
CN-A- 112 073 157  US-A1- 2011 280 345

• **MARIO COLLOTTA ET AL: "Bluetooth 5: a
concrete step forward towards the IoT",
ARXIV.ORG, CORNELL UNIVERSITY LIBRARY,
201 OLIN LIBRARY CORNELL UNIVERSITY
ITHACA, NY 14853, 1 November 2017
(2017-11-01), XP081284131,**

**Description**

This application claims the priority of Chinese patent application No. 202011255688.X filed before the Chinese Patent Office on November 11, 2020.

**TECHNICAL FIELD**

The present application relates to the field of low-power-consumption Bluetooth design technologies, and relates to a decoding implementation method of a Bluetooth receiver.

**BACKGROUND**

To meet the needs of long-distance transmission, convolutional codes (2,1,4) are added in Bluetooth 5.0 to convolutionally encode packet information, so that a receiving end can correct wrong bits in the transmission process. Viterbi decoding method is a frequently-used decoding method in a Bluetooth receiver, but in the Bluetooth receiver, the existing Viterbi decoding adopts one backtracking method from the beginning to the end. However, a packet format of Bluetooth 5.0 in a coded mode has its own special format, and a chip rate is only 1 M chip per-second. Therefore, for a special format of a received signal of the Bluetooth receiver, it is necessary to design the decoding process and the backtracking method according to these characteristics, instead of adopting one backtracking method from the beginning to the end, so as to meet the decoding requirements under low-power-consumption condition.

Mario Collotta et al., "Bluetooth 5: a concrete step towards the Iot", arxiv.or, Cornell University Library, arXiv: 1711.00257, 11 November 2017, available from https://doi.org/10.48550/arXiv.1711.00257, discloses technical features included in Bluetooth 5.

WO2016057431 A1 discloses a method of fast link adaptation for Bluetooth long-range wireless networks and a data packet comprising a preamble, a first packet portion including a rate indication field, and a second packet portion including a PDU.

**SUMMARY**

The present application provides a decoding implementation method of a Bluetooth receiver according to claim 1, which solves the problems of high power consumption and low decoding efficiency of viterbi decoding in the Bluetooth receiver in the related art.

In an implementation, the SMU includes B memory blocks, B≥3, and the memory block is configured to store survivor-paths.

In an implementation, the performing block-by-block decoding and backtracking on the second FEC block first includes:

storing the survivor-path of the second FEC block in a first memory block and a second memory block of the SMU, backtracking the second FEC block after memory spaces of the first memory block and the second memory block are both filled, and storing a new survivor-path of the second FEC block in a third memory block of the SMU when backtracking the second FEC block; and

in the case that the backtracking of the second FEC block enters the first memory block through the second memory block, outputting all bit information obtained in the backtracking of the first memory block as a decoded output;

after a memory space of the third memory block is filled, setting the second memory block and the third memory block as backtracking the second FEC block, setting the first memory block as storing the new survivor-path of the second FEC block, and circularly performing the following operations: after the memory spaces of the current two memory blocks of the SMU sequentially storing the survivor-path of the second FEC block are both filled, backtracking the second FEC block, storing the new survivor-path of the second FEC block in the remaining one memory block of the SMU, and in the case that the backtracking of the second FEC block enters the previous memory block through the latter memory block of the current two memory blocks storing the survivor-path, outputting all bit information obtained in the backtracking of the previous memory block as a decoded output, and after the memory space of the remaining one memory block is filled, setting the latter memory block and the remaining one memory block as backtracking the second FEC block, and setting the previous memory block as storing the new survivor-path of the second FEC block.

In an implementation, a storage length of each memory block in the SMU is set as N, a total storage length of the SMU is set as B*N, and the second length threshold is set as the total storage length of the SMU.

In an implementation, when performing block-by-block decoding and backtracking on the second FEC block, a decoded result is outputted in a Last Input First Output (LIFO) mode.

In an implementation, the sequentially outputting the coded indicator and the access address of the first FEC block includes:

storing the survivor-path of the first FEC block into the SMU, when the stored data length of the SMU reaches a coded input bit length a of the first FEC block, decoding and backtracking the first FEC block, outputting the bit information obtained by decoding and backtracking by a FIFO mode, outputting the coded indicator from a backtracking time $a_2$, and outputting the access address from a backtracking time $a_1+a_2$, wherein $a_1$ is a length value of the coded indicator and $a_2$ is a length value of a register null indicator included in the first FEC block.

In an implementation, each memory block in the SMU is a memory matrix of 8*N, a total storage length of the SMU is B*N bits, and a width of the SMU is 8 bits.

## BRIEF DESCRIPTION OF THE DRAWINGS

FIG. 1 is a packet format of Bluetooth 5.0 in a coded Physical layer (PHY) mode; and

FIG. 2 is a flowchart of a low-power-consumption viterbi decoding implementation method of a Bluetooth receiver provided by an embodiment of the present application.

## DETAILED DESCRIPTION

The present application is described below with reference to the accompanying drawings and the specific embodiments.

A Viterbi decoder usually consists of a Branch-Metric Generate (BMG) unit, an Add Compare Select (ACS) unit, a PathMetricUnit (PMU), a SMU, a Trace-Back-Unit (TBU) and a Control block. The functions of the above units or blocks are as follows:

1) The BMG unit is responsible for calculating a branchmetric value of jumping from a state at the current moment to a state at next moment.

2) The ACS unit receives the calculated branchmetric value from the BMG and adds the branchmetric value to a path accumulated value stored in the PMU at the previous moment to obtain metric values of two input paths. After comparison, selected survivor-paths and selected survivor-path metric values are stored in SMU and PMU paths respectively.

3) When a required moment is reached, a path with the smallest path metric value is selected from the survivor-paths. The TBU backtracks the path to generate a decoded output.

4) The Control block controls actions of the plurality of units above.

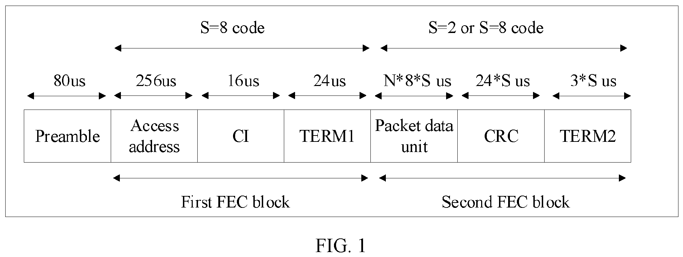

FIG. 1 is a packet format of Bluetooth 5.0 in coded PHYsical layer (PHY) mode. Each Bluetooth data includes such three blocks as a preamble (Preamble), a first FEC block (FEC block 1) and a second FEC block (FEC block 2). The preamble does not participate in coding and decoding. The first FEC block includes three fields: access address (Access Address), CodedIndicator (CI) and register null indicator (TERM1). The first FEC block uses a coding scheme of S=8, and S is a spreading factor. The second FEC block includes three fields: a Packet Data Unit (PDU), Cyclic Redundancy Check (CRC) data and a register null indicator (TERM2). The second FEC block uses a coding scheme of S=2 or S=8. When S=8, information bit needs to be expanded with 0011 (corresponding to bit 0) or 1100 (corresponding to bit 1), and then convolutional code is performed. When S=2, convolutional code is directly performed. The CI determines the coding scheme of the second FEC block. When CI=00, a spreading factor S of the second FEC block is equal to 8; and when CI=01, the spreading factor S of the second FEC block is equal to 2. Information bits corresponding to TERM1 and TERM2 are both 000, which are used to reset a status register to zero when coding. The PDU contains a 16-bit packet header and a packet payload of multiple bytes (0 to 255). The packet header indicates a byte number of the payload part.

A coded input bit length of the first FEC block in the packet format of Bluetooth 5.0 in a coded PHY mode is 37, wherein CI has two bits (00 or 01) and the register null indicator is 000. A length of a packet header in a packet data unit of the second FEC block is 16 bits, a length of a packet payload is b4, a length of check data is 24 bits, and the register null indicator is 000.

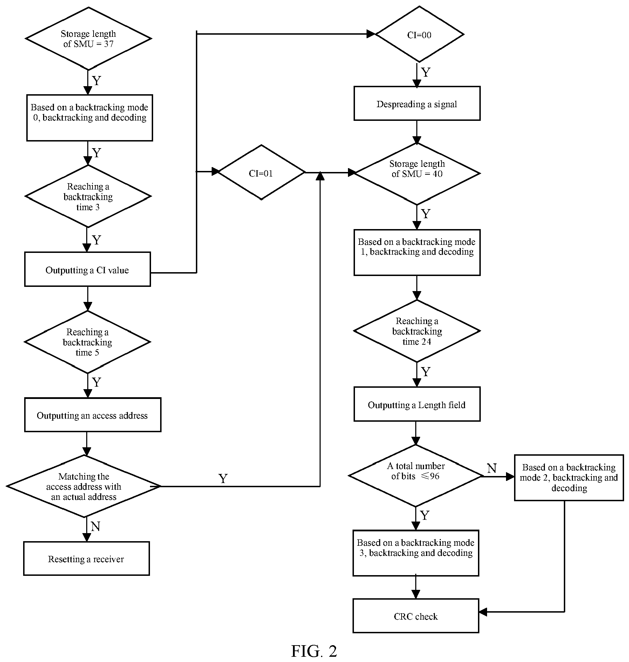

According to this data packet format, this embodiment proposes to decode the first FEC block and the second FEC block respectively. From the point of view of reducing power consumption, block-by-block backtracking is adopted for decoding. The SMU is divided into B memory blocks, which are set as storing survivor-paths, wherein B≥3, and each memory block is a memory matrix of 8*N. A total storage length of the SMU is B*N bits, and a width of the SMU is 8 bits. 8 bits exactly correspond to 8 states of convolutional codes (2,1,4). In this embodiment, taking B=3 and N=32 as examples, values of B and N can be flexibly determined according to the task requirements in practice. As shown in FIG. 2, a low-power-consumption viterbi decoding implementation method of the Bluetooth receiver includes the following steps.

A first length threshold and a second length threshold are set, wherein the first length threshold is a sum of the length of the packet header and the length of the check data in the second FEC block, i.e.,, 40. The second length threshold is 96 (3*32).

1. The first FEC block is decoded.

A survivor-path of the first FEC block is stored in the SMU. A coded input bit length of the first FEC block is 37, and TERM1 is used to make a coder state return to zero. Therefore, a decoding and backtracking length is 37, backtracking starts from 000 state, and bit information obtained from a backtracking time 0 will be used for output. A FIFO mode (decoded bits obtained first in one-time backtracking are output first) or a LIFO mode (decoded bits obtained last in one-time backtracking are output first) may be used for output of the TBU. But for the first FEC block, a FIFO mode needs to be employed. This is because that the decoding of the second FEC block needs the support of CI information. If CI is 00, the second FEC block needs to despread and then convolution decoding is carried out; and if CI is 01, convolution decoding is directly performed on the second FEC block.

If the LIFO mode is emploied in backtracking output, the CI information can only be obtained after the access address is output, and the waiting time of the second FEC block is too long, which is not beneficial for the decoder to input at a constant speed. A decoding end signal is output after decoding the first FEC block to reset the decoder and indicate that the second FEC block may be decoded. The backtracking mode here is defined as backtracking mode 0. In this mode, backtracking starts from the 000 state, and the bit information obtained from the backtracking time 0 will be used for output, and the FIFO mode is employed for output. Two-bit CI is output from a backtracking time 3, and the access address is continuously output from a backtracking time 5.

After the CI is output, it can be determined whether the second FEC block needs despreading according to the CI. If CI=00, the second FEC block needs despreading, then the second FEC block kis despreaded; and if CI=01, the second FEC block does not need despreading, and waits for decoding.

After the access address is output, the access address is matched with an actual address. If the access address is successfully matched with the actual address, the second FEC block is waiting for decoding. If the access address is not successfully matched with the actual address, the Bluetooth receiver is reset.

2. The second FEC block is decoded. This step is divided into two parts including first-stage decoding and second-stage decoding of the second FEC block. The first-stage decoding is used to obtain the length of the packet payload. The actual length of the payload is 0 butes to 255 bytes, which is indicated by a Length field in the packet header in the PDU. This is because that the length of the packet payload needs to be determined first. If the length of the packet payload is not determined first and the length of the packet payload is very short, the decoder will run to a wrong moment beyond Bluetooth data. When the length of the payload is zero, the coded input bit length of the second FEC block is 40 bits (16-bit packet header plus 24-bit CRC, excluding TERM2), so the first length threshold is set to be 40. When the storage length of the SMU reaches 40, the first-stage decoding of the second FEC block is performed. The second-stage decoding refers to decoding and backtracking the second FEC block and outputting a normal decoded bit stream in the case that whether the total number of bits of the second FEC block exceeds the storage length of the SMU is determined, including the followings.

1) First-stage decoding: the survivor-path of the second FEC block is stored in the SMU, and when the data length stored in the SMU reaches 40, the data stored in the SMU is decoded and backtracked, the backtracking mode here is defined as backtracking mode 1, in which backtracking starts from the path with the smallest path metric value, and the bit information obtained from the backtracking time time 0 is used for output, which is output in a FIFO mode, and the length of the packet payload is taken out from a backtracking time 24 to a backtracking time 31 to guide a subsequent decoding operation. At the backtracking time 31, an indicator signal is sent, indicating that the first-stage decoding of decodeing the second FEC block is finished. In order to ensure the correctness and coherence of decoding as much as possible, the 40-bit survivor-path information stored in the SMU is still used for subsequent decoding.

2) Second-stage decoding: According to the length of the packet payload, whether the total number of bits of the second FEC block exceeds the total storage length (96) of the SMU is judged, and different decoding and backtracking methods are selected according to the result whether the total number of bits of the second FEC block exceeds 96. If the total number of bits of the second FEC block does not exceed 96, one-time backtracking is performed on the second FEC block to complete decoding. If the total number of bits of the second FEC block exceeds the second length threshold, block-by-block decoding and backtracking are performed on the second FEC block first until the number of decoded remaining bits does not exceed 96, and then one-time decoding and backtracking are performed on the remaining bits for output. In the normal block-by-block decoding backtracking operation, the number of decoded bits output in each time is fixed (B bits), and a LIFO mode is employed for output. This backtracking mode is defined as backtracking mode 2. When the total number of bits of the second FEC block or the remaining number of bits after repeated block-by-block decoding and backtracking does not exceed 96, a one-time decoding and backtracking operation is performed. In this operation, the backtracking starts from the 000 state, and the bit information obtained from the backtracking time 3 is used for output, and a LIFO mode is employed for output. The backtracking mode in this operaiton is defined as a backtracking mode 3. In general viterbi decoding, there are usually two backtracking modes, namely, block-by-block backtracking and bit-by-bit backtracking. In this method, block-by-block backtracking is adopted. The block-by-block decoding and backtracking and the bit-by-bit decoding and backtracking are explained below.

A coded stream output rate of Bluetooth 5.0 in a coded PHY mode is 1 Mbps. Considering the processing delay and power consumption and other indexes of the physical layer, a working clock of the decoder may be set at 16 MHz. The TBU of the decoder occupies a large power consumption, and the backtracking modes usually include bit-by-bit backtracking and block-by-block backtracking. In bit-by-bit backtracking, one decoded bit is output in each time, while in block-by-block backtracking, multiple output bits are generated in each time. The former will consume more power, but the decoding delay is relatively small, and registered resources required by the SMU are relatively small. Because the working clock of the decoder in this method is 16 times of a rate of decoding the input code stream, and a number of states of the convolutional codes (2,1,4) is only 8, the power consumption is in a more important design index position compared with the decoding delay and the registered resources. Therefore, the block-by-block backtracking mode is employed in this method.

When the block-by-block backtracking is emplloyed, the SMU is divided into B memory blocks, and each memory block is a memory matrix of 8*N. For instance, the SMU is divided into three memory matrices $C^{(i)}(i=0,1,2)$ of 8x32.

$$c_{m,n}^{(i)} (m = 0,1,\cdots,7, \ n = 0,1,\cdots,31)$$

represents an element in an m-th row and an *n*-th column of the matrix $C^{(i)}$, which stores coded input bit information corresponding to a survivor-path entering a state *m,* and this path is remained after ACS operation on all paths entering the state *m* at the current moment. According to this bit information, a state at the previous moment transferred to the current state may be inferred. These three memory matrices will form a large cyclic memory block. For example, when the matrices $C^{(0)}$ and $C^{(1)}$ are filled in the decoding process, the backtracking is started. At the same time of backtracking, new survivor-path information is written into the matrix $C^{(2)}$. Because 32 is equal to 8 times of a constraint length of the convolutional codes (2,1,4), the path information of all the survivor-paths in the matrix $C^{(0)}$ is usually merged into one path. Therefore, in the backtracking operation, the path with the smallest path metric value is selected from all the survivor-paths for backtracking. When the backtracking enters the matrix $C^{(0)}$ through the matrix $C^{(1)}$, all the bit information obtained from the backtracking in the matrix $C^{(0)}$ may be used as a decoded output.

Compared with an information bit stream at a sending end, the decoded bit information directly obtained by backtracking is actually LIFO. If FIFO is needed, the decoded bit information needs to be stored in a Random Access Memory (RAM) first, and then output according to FIFO rules. It takes about 64 clock cycles to complete a normal backtracking, which is equivalent to 4 symbol cycles. Therefore, after the backtracking is completed, the matrix $C^{(2)}$ has not been filled yet, but the information of the matrix $C^{(0)}$ has been used up, and new new survivor-path information may be stored. When the matrix $C^{(2)}$ is filled, the matrices $C^{(1)}$ and $C^{(2)}$ may be used for the backtracking operation, while the matrix $C^{(0)}$ may be written with new survivor-path information.Follow-up operations are cycled accordingly. Until the last backtracking, the number of decoded remaining bits does not exceed 96. In this case, all the decoded remaining bits are regarded as decoded correct bits and output, so the last backtracking is to directly backtrack all the decoded bits.

It can be seen from the above that the low-power-consumption viterbi decoding implementation method of the Bluetooth receiver relates to four backtracking modes in total, which shows that the design of the backtracking part is very critical and has important influence on power consumption, delay and complexity. Therefore, the present application combines the conditions of Bluetooth 5.0 in terms of rate, packet format and coding characteristics, and proposes a block-by-block backtracking method according to the characteristics of the packet format and the convolutional codes (2,1,4) of Bluetooth 5.0, which can make full use of the registered resources, reduce the power consumption and reduce the time delay.

## Claims

1. A decoding implementation method for a Bluetooth receiver, comprising:

    setting a first length threshold and a second length threshold, wherein a received signal of the Bluetooth receiver comprises a preamble, a first Forward Error Correction, FEC, block and a second FEC block, the first FEC block includes an access address, a coded indicator and a register return-to-zero indicator, the second FEC block comprises a packet data unit, check data and a further register return-to-zero indicator, wherein information bits corresponding to the register return-to-zero indicator and the further register return-to-zero indicator are both 000, the packet data unit comprises a packet header and a packet payload, wherein the packet header comprises a length field which indicates the length of the packet payload, and the first length threshold is a sum of a length of the packet header and a length of the check data;
    storing a survivor-path of the first FEC block in a Survivor-path Memory Unit SMU, decoding and backtracking the first FEC block, and sequentially outputting the coded indicator and the access address of the first FEC block in a First Input First Output FIFO mode, wherein the SMU comprises B memory blocks and wherein a storage length of each memory block in the SMU is set as N, a total storage length of the SMU is set as B*N, and the second length threshold is set as the total storage length of the SMU;
    determining whether the second FEC block needs despreading according to the coded indicator, if the second FEC block needs despreading, despreading the second FEC block and waiting for decoding the despread second FEC block, and if the second FEC block does not need despreading, waiting for decoding the second FEC block;

matching the access address with an actual address of the Bluetooth receiver, if the access address is successfully matched with the actual address, waiting for decoding the second FEC block, and if the access address is not successfully matched with the actual address, resetting the Bluetooth receiver;

storing a survivor-path of the second FEC block into the SMU, when the length of data stored in the SMU reaches the first length threshold, decoding and backtracking the data stored in the SMU, outputting bit information obtained by decoding and backtracking in a FIFO mode, storing the survivor-path of the second FEC block into the SMU, when the data length stored in the SMU reaches b1+b2, decoding and backtracking the second FEC block, outputting the bit information obtained by decoding and backtracking in a FIFO mode, taking out a length field of the packet payload in the packet header from a backtracking time b2, and determining the length of the packet payload, wherein b1 is a length value of the packet header, and b2 is a length value of the check data and wherein, when performing one-time backtracking on the second FEC block to complete decoding in response to that the total number of bits of the second FEC block does not exceed the second length threshold, a decoded result is output from a backtracking time b3, wherein b3 is a length value of the further register return-to-zero indicator comprised in the second FEC block; and judging whether a total number of bits of the second FEC block exceeds the second length threshold according to the length of the packet payload, and in response to that the total number of bits of the second FEC block does not exceed the second length threshold, performing one-time backtracking on the second FEC block to complete decoding; and in response to that the total number of bits of the second FEC block exceeds the second length threshold, performing block-by-block decoding and backtracking on the second FEC block first, outputting a decoded stream with a fixed number of bits in each time, and in the case that a number of remaining bits after the block-by-block decoding does not exceed the second length threshold, performing one-time backtracking on the remaining bits to complete decoding.

2. The method according to claim 1, wherein B≥ 3, and the memory block is configured to store survivor-paths.

3. The method according to claim 2, wherein the performing block-by-block decoding and backtracking on the second FEC block first comprises:

storing the survivor-path of the second FEC block in a first memory block and a second memory block of the SMU, backtracking the second FEC block after memory spaces of the first memory block and the second memory block are both filled, and storing a new survivor-path of the second FEC block in a third memory block of the SMU when backtracking the second FEC block; and

in the case that the backtracking of the second FEC block enters the first memory block through the second memory block, outputting all bit information obtained in the backtracking of the first memory block as a decoded output; after a memory space of the third memory block is filled, setting the second memory block and the third memory block as backtracking the second FEC block, setting the first memory block as storing the new survivor-path of the second FEC block, and circularly performing the following operations: after the memory spaces of the current two memory blocks of the SMU sequentially storing the survivor-path of the second FEC block are both filled, backtracking the second FEC block, storing the new survivor-path of the second FEC block in the remaining one memory block of the SMU, and in the case that the backtracking of the second FEC block enters the previous memory block through the latter memory block of the current two memory blocks storing the survivor-path, outputting all bit information obtained in the backtracking of the previous memory block as a decoded output, and after the memory space of the remaining one memory block is filled, setting the latter memory block and the remaining one memory block as backtracking the second FEC block, and setting the previous memory block as storing the new survivor-path of the second FEC block.

4. The method according to any one of claims 1 to 3, wherein when performing block-by-block decoding and backtracking on the second FEC block, a decoded result is outputted in a Last Input First Output LIFO mode.

5. The method according to any one of claims 1 to 3, wherein the sequentially outputting the coded indicator and the access address of the first FEC block comprises:

storing the survivor-path of the first FEC block into the SMU, when the stored data length of the SMU reaches a coded input bit length a of the first FEC block, decoding and backtracking the first FEC block, outputting the bit information obtained by decoding and backtracking by a FIFO mode, outputting the coded indicator from a backtracking time a2, and outputting the access address from a backtracking time a1+a2, wherein a1 is a length value of the coded indicator and a2 is a length value of the register return-to-zero indicator comprised in the first FEC block.

6. The method according to claim 2 or 3, wherein each memory block in the SMU is a memory matrix of 8*N, a total storage length of the SMU is B*N bits, and a width of the SMU is 8 bits.

**Patentansprüche**

1. Ein Decodierungsimplementierungsverfahren für einen Bluetooth-Empfänger, beinhaltend:

Festlegen eines ersten Längenschwellenwerts und eines zweiten Längenschwellenwerts, wobei ein empfangenes Signal des Bluetooth-Empfängers eine Präambel, einen ersten Vorwärtsfehlerkorrektur-Block, FEC-Block, und einen zweiten FEC-Block beinhaltet, wobei der erste FEC-Block eine Zugriffsadresse, einen codierten Indikator und einen Register-Return-to-Zero-Indikator umfasst, wobei der zweite FEC-Block eine Paketdateneinheit, Prüfdaten und einen weiteren Register-Return-to-Zero-Indikator beinhaltet, wobei Informationsbits, die dem Register-Return-to-Zero-Indikator und dem weiteren Register-Return-to-Zero-Indikator entsprechen, jeweils 000 sind,
wobei die Paketdateneinheit einen Paketkopf und eine Paketnutzlast beinhaltet, wobei der Paketkopf ein Längenfeld beinhaltet, das die Länge der Paketnutzlast angibt, und der erste Längenschwellenwert eine Summe aus einer Länge des Paketkopfs und einer Länge der Prüfdaten ist;
Speichern eines Überlebenspfads des ersten FEC-Blocks in einer Überlebenspfad-Speichereinheit SMU, Decodieren und Rückverfolgen des ersten FEC-Blocks und sequentielles Ausgeben des codierten Indikators und der Zugriffsadresse des ersten FEC-Blocks in einem First-Input-First-Output-FIFO-Modus, wobei die SMU B Speicherblöcke beinhaltet und wobei eine Speicherlänge jedes Speicherblocks in der SMU auf N festgelegt ist, eine Gesamtspeicherlänge der SMU auf B * N festgelegt ist und der zweite Längenschwellenwert als die Gesamtspeicherlänge der SMU festgelegt ist;
Bestimmen, ob der zweite FEC-Block gemäß dem codierten Indikator entspreizt werden muss, falls der zweite FEC-Block entspreizt werden muss, Entspreizen des zweiten FEC-Blocks und Warten auf die Decodierung des entspreizten zweiten FEC-Blocks, und falls der zweite FEC-Block nicht entspreizt werden muss, Warten auf die Decodierung des zweiten FEC-Blocks;
Abgleichen der Zugriffsadresse mit einer tatsächlichen Adresse des Bluetooth-Empfängers, falls die Zugriffsadresse erfolgreich mit der tatsächlichen Adresse abgeglichen wird, Warten auf die Decodierung des zweiten FEC-Blocks, und falls die Zugriffsadresse nicht erfolgreich mit der tatsächlichen Adresse abgeglichen wird, Zurücksetzen des Bluetooth-Empfängers;
Speichern eines Überlebenspfads des zweiten FEC-Blocks in der SMU, wenn die in der SMU gespeicherte Datenlänge den ersten Längenschwellenwert erreicht, Decodieren und Rückverfolgen der in der SMU gespeicherten Daten, Ausgeben der durch Decodierung und Rückverfolgung erhaltenen Bitinformationen in einem FIFO-Modus, Speichern des Überlebenspfads des zweiten FEC-Blocks in der SMU, wenn die in der SMU gespeicherte Datenlänge b1 + b2 erreicht, Decodieren und Rückverfolgen des zweiten FEC-Blocks, Ausgeben der durch Decodierung und Rückverfolgung erhaltenen Bitinformationen in einem FIFO-Modus, Herausnehmen eines Längenfelds der Paketnutzlast in dem Paketkopf ab einer Rückverfolgungszeit b2 und Bestimmen der Länge der Paketnutzlast, wobei b1 ein Längenwert des Paketkopfs ist und b2 ein Längenwert der Prüfdaten ist und wobei beim Durchführen einer einmaligen Rückverfolgung an dem zweiten FEC-Block zum Abschließen der Decodierung als Reaktion darauf, dass die Gesamtzahl der Bits des zweiten FEC-Blocks den zweiten Längenschwellenwert nicht überschreitet, ein decodiertes Ergebnis ab einer Rückverfolgungszeit b3 ausgegeben wird, wobei b3 ein Längenwert des weiteren Register-Return-to-Zero-Indikators ist, der in dem zweiten FEC-Block enthalten ist; und
Beurteilen, ob eine Gesamtzahl der Bits des zweiten FEC-Blocks den zweiten Längenschwellenwert gemäß der Länge der Paketnutzlast überschreitet, und als Reaktion darauf, dass die Gesamtzahl der Bits des zweiten FEC-Blocks den zweiten Längenschwellenwert nicht überschreitet, Durchführen einer einmaligen Rückverfolgung an dem zweiten FEC-Block zum Abschließen der Decodierung; und als Reaktion darauf, dass die Gesamtzahl der Bits des zweiten FEC-Blocks den zweiten Längenschwellenwert überschreitet, Durchführen einer blockweisen Decodierung und Rückverfolgung zuerst an dem zweiten FEC-Block, Ausgeben eines decodierten Stroms mit einer festen Anzahl an Bits jedes Mal, und in dem Fall, dass eine Anzahl an verbleibenden Bits nach der blockweisen Decodierung den zweiten Längenschwellenwert nicht überschreitet, Durchführen einer einmaligen Rückverfolgung an den verbleibenden Bits zum Abschließen der Decodierung.

2. Verfahren gemäß Anspruch 1, wobei B ≥ 3 und der Speicherblock zum Speichern von Überlebenspfaden konfiguriert ist.

3. Verfahren gemäß Anspruch 2, wobei das Durchführen einer blockweisen Decodierung und Rückverfolgung zuerst an dem zweiten FEC-Block Folgendes beinhaltet:

Speichern des Überlebenspfads des zweiten FEC-Blocks in einem ersten Speicherblock und einem zweiten Speicherblock der SMU, Rückverfolgen des zweiten FEC-Blocks, nachdem Speicherplätze des ersten Speicherblocks und des zweiten Speicherblocks beide gefüllt sind, und Speichern eines neuen Überlebenspfads des zweiten FEC-Blocks in einem dritten Speicherblock der SMU bei der Rückverfolgung des zweiten FEC-Blocks; und
in dem Fall, dass die Rückverfolgung des zweiten FEC-Blocks über den zweiten Speicherblock in den ersten Speicherblock gelangt, Ausgeben aller bei der Rückverfolgung des ersten Speicherblocks erhaltenen Bitinformationen als eine decodierte Ausgabe; nachdem ein Speicherplatz des dritten Speicherblocks gefüllt ist, Festlegen des zweiten Speicherblocks und des dritten Speicherblocks so, dass sie den zweiten FEC-Block rückverfolgen, Festlegen des ersten Speicherblocks so, dass er den neuen Überlebenspfad des zweiten FEC-Blocks speichert, und zirkuläres Durchführen der folgenden Vorgänge: nachdem die Speicherplätze der aktuellen zwei Speicherblöcke der SMU, die sequenziell den Überlebenspfad des zweiten FEC-Blocks speichern, beide gefüllt sind, Rückverfolgen des zweiten FEC-Blocks, Speichern des neuen Überlebenspfads des zweiten FEC-Blocks in dem verbleibenden einen Speicherblock der SMU, und in dem Fall, dass die Rückverfolgung des zweiten FEC-Blocks über den letzteren Speicherblock der aktuellen zwei Speicherblöcke, die den Überlebenspfad speichern, in den vorherigen Speicherblock gelangt, Ausgeben aller bei der Rückverfolgung des vorherigen Speicherblocks erhaltenen Bitinformationen als eine decodierte Ausgabe, und nachdem der Speicherplatz des verbleibenden einen Speicherblocks gefüllt ist, Festlegen des letzteren Speicherblocks und des verbleibenden einen nen Speicherblocks so, dass sie den zweiten FEC-Block rückverfolgen, und Festlegen des vorherigen Speicherblocks so, dass er den neuen Überlebenspfad des zweiten FEC-Blocks speichert.

4. Verfahren gemäß einem der Ansprüche 1 bis 3, wobei beim Durchführen einer blockweisen Decodierung und Rückverfolgung an dem zweiten FEC-Block ein decodiertes Ergebnis in einem Last-Input-First-Output-LIFO-Modus ausgegeben wird.

5. Verfahren gemäß einem der Ansprüche 1 bis 3, wobei das sequenzielle Ausgeben des codierten Indikators und der Zugriffsadresse des ersten FEC-Blocks Folgendes beinhaltet:
Speichern des Überlebenspfads des ersten FEC-Blocks in der SMU, wenn die gespeicherte Datenlänge der SMU eine Codierungseingangsbitlänge a des ersten FEC-Blocks erreicht, Decodieren und Rückverfolgen des ersten FEC-Blocks, Ausgeben der durch Decodierung und Rückverfolgung erhaltenen Bitinformationen durch einen FIFO-Modus, Ausgeben des codierten Indikators ab einer Rückverfolgungszeit a2 und Ausgeben der Zugriffsadresse ab einer Rückverfolgungszeit a1 + a2, wobei a1 ein Längenwert des codierten Indikators ist und a2 ein Längenwert des Register-Return-to-Zero-Indikators, der in dem ersten FEC-Block enthalten ist, ist.

6. Verfahren gemäß Anspruch 2 oder 3, wobei jeder Speicherblock in der SMU eine Speichermatrix von 8 * N ist, eine Gesamtspeicherlänge der SMU B * N beträgt und eine Breite der SMU 8 Bits beträgt.

**Revendications**

1. Un procédé de mise en oeuvre de décodage pour un récepteur Bluetooth, comprenant :

le fait de définir un premier seuil de longueur et un deuxième seuil de longueur, où un signal reçu du récepteur Bluetooth comprend un préambule, un premier bloc de correction d'erreurs sans voie de retour, FEC, et un deuxième bloc FEC, le premier bloc FEC inclut une adresse d'accès, un indicateur codé et un indicateur de retour à zéro de registre, le deuxième bloc FEC comprend une unité de données de paquet, des données de contrôle et un indicateur de retour à zéro de registre supplémentaire, où des bits d'information correspondant à l'indicateur de retour à zéro de registre et à l'indicateur de retour à zéro de registre supplémentaire sont tous deux 000, l'unité de données de paquet comprend un en-tête de paquet et une charge utile de paquet, où l'en-tête de paquet comprend un champ de longueur qui indique la longueur de la charge utile de paquet, et le premier seuil de longueur est une somme d'une longueur de l'entête de paquet et d'une longueur des données de contrôle ;

le fait de stocker un chemin survivant du premier bloc FEC dans une unité de mémoire de chemin survivant SMU, le fait de décoder et le fait de remonter le premier bloc FEC, et séquentiellement le fait de sortir l'indicateur codé et l'adresse d'accès du premier bloc FEC dans un mode première entrée première sortie FIFO, où la SMU comprend des blocs mémoire B et où une longueur de stockage de chaque bloc mémoire dans la SMU est définie comme N, une longueur de stockage totale de la SMU est définie comme B*N, et le deuxième seuil de longueur est défini comme la longueur de stockage totale de la SMU ;

le fait de déterminer si le deuxième bloc FEC a besoin d'un désétalement selon l'indicateur codé, si le deuxième bloc FEC a besoin d'un désétalement, le fait de désétaler le deuxième bloc FEC et le fait d'attendre pour décoder le deuxième bloc FEC désétalé, et si le deuxième bloc FEC n'a pas besoin d'un désétalement, le fait d'attendre pour décoder le deuxième bloc FEC ;

le fait d'apparier l'adresse d'accès avec une adresse réelle du récepteur Bluetooth, si l'adresse d'accès est appariée avec succès avec l'adresse réelle, le fait d'attendre pour décoder le deuxième bloc FEC, et si l'adresse d'accès n'est pas appariée avec succès avec l'adresse actuelle, le fait de redéfinir le récepteur Bluetooth ;

le fait de stocker un chemin survivant du deuxième bloc FEC dans la SMU, lorsque la longueur de données stockées dans la SMU atteint le premier seuil de longueur, le fait de décoder et le fait de remonter les données stockées dans la SMU, le fait de sortir des informations de bit obtenues par décodage et remontée dans un mode FIFO, le fait de stocker le chemin survivant du deuxième bloc FEC dans la SMU, lorsque la longueur de données stockées dans la SMU atteint b1+b2, le fait de décoder et de remonter le deuxième bloc FEC, le fait de sortir les informations de bit obtenues par décodage et remontée dans un mode FIFO, le fait d'enlever un champ de longueur de la charge utile de paquet dans l'en-tête de paquet d'un temps de remontée b2, et le fait de déterminer la longueur de la charge utile de paquet, où b1 est une valeur de longueur de l'en-tête de paquet, et b2 est une valeur de longueur des données de contrôle et où, lors de la réalisation d'une remontée unique sur le deuxième bloc FEC afin de terminer le décodage en réponse au fait que le nombre total de bits du deuxième bloc FEC ne dépasse pas le deuxième seuil de longueur, un résultat décodé est sorti d'un temps de remontée b3, où b3 est une valeur de longueur de l'indicateur de retour à zéro de registre supplémentaire compris dans le deuxième bloc FEC ; et

le fait de juger si un nombre total de bits du deuxième bloc FEC dépasse le deuxième seuil de longueur selon la longueur de la charge utile de paquet, et en réponse à ce que le nombre total de bits du deuxième bloc FEC ne dépasse pas le deuxième seuil de longueur, le fait de réaliser une remontée unique sur le deuxième bloc FEC afin de terminer le décodage ; et en réponse à ce que le nombre total de bits du deuxième bloc FEC dépasse le deuxième seuil de longueur, le fait de réaliser un décodage et une remontée sur le deuxième bloc FEC en premier bloc par bloc, le fait de sortir un flux décodé avec un nombre de bits fixe à chaque moment, et dans le cas où un nombre de bits restants après le décodage bloc par bloc ne dépasse pas le deuxième seuil de longueur, le fait de réaliser une remontée unique sur les bits restants afin de terminer le décodage.

2. Le procédé selon la revendication 1, où B ≥ 3, et le bloc mémoire est configuré pour stocker des chemins survivants.

3. Le procédé selon la revendication 2, où la réalisation du décodage et de la remontée sur le deuxième bloc FEC en premier bloc par bloc comprend :

le fait de stocker le chemin survivant du deuxième bloc FEC dans un premier bloc mémoire et un deuxième bloc mémoire de la SMU, le fait de remonter le deuxième bloc FEC après que des espaces de mémoire du premier bloc mémoire et du deuxième bloc mémoire sont tous deux remplis, et le fait de stocker un nouveau chemin survivant du deuxième bloc FEC dans un troisième bloc mémoire de la SMU lors de la remontée du deuxième bloc FEC ; et

dans le cas où la remontée du deuxième bloc FEC entre dans le premier bloc mémoire à travers le deuxième bloc mémoire, le fait de sortir toutes les informations de bit obtenues dans la remontée du premier bloc mémoire comme une sortie décodée ;

après qu'un espace de mémoire du troisième bloc mémoire est rempli, le fait de définir le deuxième bloc mémoire et le troisième bloc mémoire comme une remontée du deuxième bloc FEC, le fait de définir le premier bloc mémoire comme un stockage du nouveau chemin survivant du deuxième bloc FEC, et le fait de réaliser de façon circulaire les opérations suivantes :

après que les espaces de mémoire des deux blocs mémoire actuels de la SMU stockant séquentiellement le chemin survivant du deuxième bloc FEC sont tous deux remplis, le fait de remonter le deuxième bloc FEC, le fait de stocker le nouveau chemin survivant du deuxième bloc FEC dans cet un bloc mémoire restant de la SMU, et dans le cas où la remontée du deuxième bloc FEC entre dans le bloc mémoire précédent à travers le dernier bloc mémoire des deux blocs mémoires actuels stockant le chemin survivant, le fait de sortir toutes les informations de bit obtenues dans la remontée du bloc mémoire précédent comme une sortie décodée, et après que l'espace de mémoire de cet un bloc mémoire restant est rempli, le fait de définir le dernier bloc mémoire et cet un bloc mémoire restant comme la remontée du deuxième bloc FEC, et le fait de définir le bloc mémoire précédent comme le stockage du nouveau chemin survivant du deuxième bloc FEC.

4. Le procédé selon n'importe laquelle des revendications 1 à 3, où lors de la réalisation du décodage et de la remontée sur le deuxième bloc FEC bloc par bloc, un résultat décodé est sorti dans un mode dernière entrée première sortie LIFO.

5. Le procédé selon n'importe laquelle des revendications 1 à 3, où la sortie séquentielle de l'indicateur codé et de l'adresse d'accès du premier bloc FEC comprend :
le fait de stocker le chemin survivant du premier bloc FEC dans la SMU, lorsque la longueur de données stockée de la SMU atteint une longueur de bit d'entrée codée a du premier bloc FEC, le fait de décoder et de remonter le premier bloc FEC, le fait de sortir les informations de bit obtenues par décodage et remontée par un mode FIFO, le fait de sortir l'indicateur codé d'un temps de remontée a2, et le fait de sortie l'adresse d'accès d'un temps de remontée a1+a2, où a1 est une valeur de longueur de l'indicateur codé et a2 est une valeur de longueur de l'indicateur de retour à zéro de registre compris dans le premier bloc FEC.

6. Le procédé selon la revendication 2 ou la revendication 3, où chaque bloc mémoire dans la SMU est une matrice de mémoire de 8*N, une longueur de stockage totale de la SMU est de B*N bits, et une largeur de la SMU est de 8 bits.

| | S=8 code | | | S=2 or S=8 code | | |
|---|---|---|---|---|---|---|
| 80us | 256us | 16us | 24us | N*8*S us | 24*S us | 3*S us |
| Preamble | Access address | CI | TERM1 | Packet data unit | CRC | TERM2 |
| | First FEC block | | | Second FEC block | | |

FIG. 1

FIG. 2

**EP 4 027 550 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202011255688X

- WO 2016057431 A1

**Non-patent literature cited in the description**

- Bluetooth 5: a concrete step towards the Iot. **MARIO COLLOTTA et al.** arxiv.or. Cornell University Library, 11 November 2017